(19) Europäisches Patentamt
European Patent Office
Office européen des brevets

(11) **EP 3 699 673 B1**

(12) **EUROPEAN PATENT SPECIFICATION**

(45) Date of publication and mention
of the grant of the patent:
**02.04.2025 Bulletin 2025/14**

(21) Application number: **20156825.0**

(22) Date of filing: **12.02.2020**

(51) International Patent Classification (IPC):
**G02B 27/28** *(2006.01)* **G02F 1/13363** *(2006.01)*
**G02B 5/30** *(2006.01)*

(52) Cooperative Patent Classification (CPC):
**G02B 27/286; G02B 27/288; G02F 1/133528;**
**H10K 59/8791;** G02B 5/3016; G02B 5/3033;
G02B 5/3083; G02F 1/133305; G02F 1/13363;
G02F 1/133638

(54) **POLARIZING PLATE AND DISPLAY DEVICE INCLUDING THE SAME**

POLARISATIONSPLATTE UND ANZEIGEVORRICHTUNG DAMIT

PLAQUE DE POLARISATION ET DISPOSITIF D'AFFICHAGE LA COMPRENANT

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **19.02.2019 KR 20190019000**

(43) Date of publication of application:
**26.08.2020 Bulletin 2020/35**

(73) Proprietor: **Samsung Display Co., Ltd.**
**Gyeonggi-do 17113 (KR)**

(72) Inventors:
• **Lee, Heeyoung**
**3202-805 Gyeonggi-do (KR)**
• **Oh, Minju**
**903-804 Gyeonggi-do (KR)**
• **Park, Gilyeong**
**1004 Chungcheongnam-do (KR)**

(74) Representative: **Dr. Weitzel & Partner**
**Patent- und Rechtsanwälte mbB**
**Friedenstrasse 10**
**89522 Heidenheim (DE)**

(56) References cited:
WO-A1-2018/021190     US-A1- 2014 168 768
US-A1- 2018 149 785     US-A1- 2019 235 148

**Description**

BACKGROUND

1. Field

The disclosure herein relates to a polarizing plate and a display device including the polarizing plate, and more particularly, to a polarizing plate including an adhesive member between optical layers and a display device including the polarizing plate.

2. Description of the Related Art

Various display devices such as a television, a mobile phone, a tablet computer, a navigation unit and a game console have been developed. In particular, a display device capable of being folded and rolled by including a flexible display member, i.e., a flexible, foldable or rollable display device, has been recently developed for easy carrying and improving convenience of a user. A polarizing plate for a flexible display is furthermore disclosed in US-A1-2018/149785.

SUMMARY

In a flexible, foldable or rollable display device, each of elements thereof is desired to have a small thickness, and particularly, when optical layers each having a small thickness are laminated, mura phenomenon caused by a light interference phenomenon between the optical layer and adjacent layers may be visible or perceived by a viewer.
The disclosure provide a polarizing plate in which mura phenomenon caused by a light interference phenomenon between an optical layer and an adhesive member is effectively prevented by adjusting a refractive index difference between the optical layer and the adhesive member disposed adjacent thereto or adjusting a thickness of the adhesive member.
The disclosure also provides a display device with improved display quality by including a polarizing plate in which a refractive index difference between an optical layer and an adhesive member disposed adjacent thereto is adjusted or a thickness of an adhesive member is adjusted.
An embodiment of the invention provides a polarizing plate as specified in appended claim 1.
In an embodiment not according to the claimed invention, the first adhesive member may be the adhesive layer, and the adhesive layer may have a glass transition temperature in a range from about 40°C to about 150°C.
In an embodiment not according to the claimed invention, the first phase retardation layer may have a refractive index equal to or greater than a refractive index of the first adhesive member, and the refractive index of the second phase retardation layer may be greater than the refractive index of the first adhesive member.
In an embodiment not according to the claimed invention, the first phase retardation layer may have a refractive index less than a refractive index of the first adhesive member, and a refractive index difference between the first phase retardation layer and the first adhesive member may be about 0.25 or less.
In an embodiment according to the claimed invention, the first adhesive member is a pressure sensitive adhesive layer, and the pressure sensitive adhesive layer has a glass transition temperature in a range from about -45°C to about 0°C.
In an embodiment, a refractive index difference between the pressure sensitive adhesive layer and the second phase retardation layer may be about 0.25 or less.
In an embodiment, the first adhesive member may have a refractive index in a range from about 1.5 to about 1.8.
In an embodiment, the first phase retardation layer may be a λ/4 phase retarder, the second phase retardation layer may be a λ/2 phase retarder, and the polarizer layer may be a linear polarizer.
In an embodiment, each of the first phase retardation layer and the second phase retardation layer may be a liquid crystal coating layer.
In an embodiment, the first phase retardation layer may be a nematic liquid crystal coating layer, and the second phase retardation layer may be a discotic liquid crystal coating layer.
In an embodiment, the polarizing plate may further include a second adhesive member disposed between the second phase retardation layer and the polarizer layer, and the second adhesive member may be a pressure sensitive adhesive layer having a glass transition temperature in a range from about -45°C to about 0°C or an adhesive layer having a glass transition temperature in a range from about 40°C to about 150°C.
In an embodiment, the polarizing plate may further include a light compensation layer disposed below the first phase retardation layer, and the light compensation layer may be a positive C-plate or a negative C-plate.
In an embodiment of the invention, a display device includes: a display panel including a light emitting element; and a polarizing plate as specified in appended claim 1 disposed on the display panel.

In an embodiment not according to the claimed invention, the first phase retardation layer may have a refractive index equal to or greater than a refractive index of the first adhesive member, and the refractive index of the second phase retardation layer may be greater than the refractive index of the first adhesive member.

In an embodiment not according to the claimed invention, the first phase retardation layer may have a refractive index less than a refractive index of the first adhesive member, and a refractive index difference between the first phase retardation layer and the first adhesive member may be about 0.25 or less.

In an embodiment, the first adhesive member is the pressure sensitive adhesive layer, and the pressure sensitive adhesive layer has a glass transition temperature in a range from about -45°C to about 0°C.

In an embodiment, the first adhesive member may have a refractive index in a range from about 1.5 to about 1.8.

In an embodiment, each of the first phase retardation layer and the second phase retardation layer may be a liquid crystal coating layer.

In an embodiment not according to the claimed invention, a display device, which has a folding area, includes: a display panel; and a polarizing plate disposed on the display panel. The polarizing plate includes: a first phase retardation layer; a second phase retardation layer disposed on the first phase retardation layer; a polarizer layer disposed on the second phase retardation layer; and an adhesive layer disposed between the first phase retardation layer and the second phase retardation layer and having a glass transition temperature in a range from about 40°C to about 150°C. In such an embodiment, a refractive index difference between the adhesive layer and the second phase retardation layer is about 0.25 or less.

In an embodiment, each of the first phase retardation layer and the second phase retardation layer may be a liquid crystal coating layer.

In an embodiment, a refractive index difference between the first phase retardation layer and the adhesive layer may be about 0.25 or less.

In an embodiment, the folding area may have a radius of curvature of about 5 millimeters (mm).

BRIEF DESCRIPTION OF THE FIGURES

The above and other features of the invention will become readily apparent by reference to the following detailed description when considered in conjunction with the accompanying drawings, in which:

FIG. 1 is a perspective view illustrating a display device according to an embodiment of the invention;
FIG. 2 is a view illustrating a folded state of the display device in FIG. 1;
FIG. 3 is a perspective view illustrating a display device according to an embodiment of the invention;
FIG. 4 is a view illustrating the display device of FIG. 3 in a folded state;
FIG. 5 is a perspective view illustrating a display device according to an embodiment of the invention;
FIG. 6 is a cross-sectional view illustrating a display device according to an embodiment;
FIG. 7 is a cross-sectional view illustrating a polarizing plate according to an embodiment;
FIG. 8 is a cross-sectional view illustrating a polarizing plate according to an alternative embodiment;
FIG. 9 is a cross-sectional view illustrating a polarizing plate according to another alternative embodiment; and
FIG. 10 is a cross-sectional view illustrating a display panel according to an embodiment.

DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

In this specification, it will also be understood that when one component (or region, layer, portion) is referred to as being 'on', 'connected to', or 'coupled to' another component, it can be directly disposed/connected/coupled on/to the one component, or an intervening third component may also be present.

On the other hand, it will be understood that when an element, a layer, an area, or a plate is directly disposed on or connected to another one, further another element, layer, area, or plate is not present therebetween. For example, a term of "directly disposed" may represent that two layers or two members are arranged without using an additional member such as an adhesive member therebetween.

Like reference numerals refer to like elements throughout. Also, in the figures, the thickness, ratio, and dimensions of components are exaggerated for clarity of illustration.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one of A and B" means "A or B." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system).

Also, "under", "below", "above', "upper", and the like are used for explaining relation association of components illustrated in the drawings. The terms may be a relative concept and described based on directions expressed in the drawings. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Unless otherwise defined, all terms (including technical and scientific terms) used herein have the same meaning as generally understood by those skilled in the art. Terms as defined in a commonly used dictionary should be construed as having the same meaning as in an associated technical context, and unless defined apparently in the description, the terms are not ideally or excessively construed as having formal meaning.

Hereinafter, embodiments of a display device and a polarizing plate according to the invention will be described in detail with reference to the accompanying drawings.

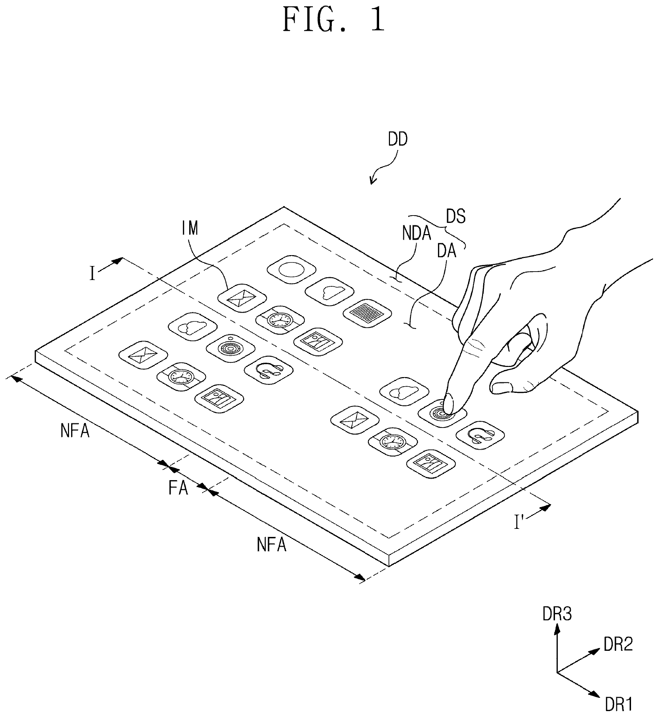

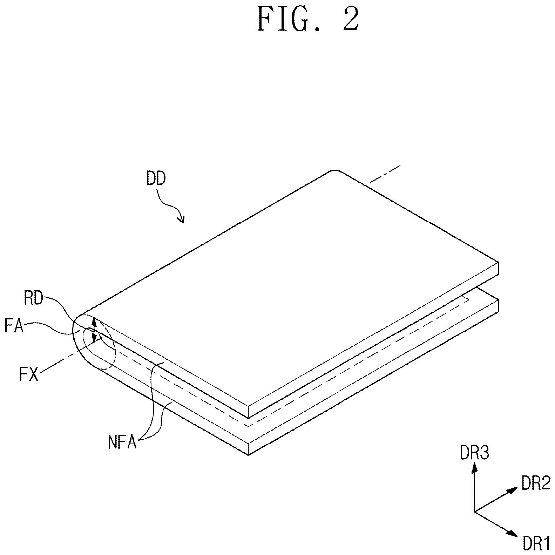

FIG. 1 is a perspective view illustrating a display device according to an embodiment of the invention. FIG. 2 is a view illustrating a folded state of the display device in FIG. 1.

Referring to FIG. 1, an embodiment of a display device DD may have a rectangular shape having long sides extending in a direction of a first directional axis DR1 and short sides extending in a direction of a second directional axis DR2 crossing the first directional axis DR1. However, the embodiment of the invention is not limited thereto. In such an embodiment, the display device DD may has one of various shapes such as a circle or a polygon, for example, on a plane. The display device DD may be a flexible display device. Herein, "on a plane" may mean "when viewed from a plan view in a thickness direction of a display device."

In an embodiment of the display device DD, a display surface DS, on which an image IM is displayed, may be defined on a plane defined by the first directional axis DR1 and the second directional axis DR2. A normal direction of the display surface DS, i.e., the thickness direction of the display device DD, indicates a third directional axis DR3. A front surface (or top surface) and a rear surface (or bottom surface) of each of members is distinguished by the third directional axis DR3. However, directions indicated by the first to third directional axes DR1, DR2, and DR3 may be a relative concept, and thus may be converted with respect to each other. Hereinafter, first to third directions may be directions indicated by the first to third directional axes DR1, DR2, and DR3, and designated by the same reference numerals, respectively.

In an embodiment, the display device DD may include a folding area FA and a non-folding area NFA. Referring to FIGS. 1 and 2, the display device DD may include a folding area FA and a plurality of non-folding areas NFA. The folding area FA may be disposed between the non-folding areas NFA, and the folding area FA and the non-folding areas NFA may be arranged next to each other in the direction of the first directional axis DR1.

The folding area FA may be a portion that is deformed into a folded shape with respect to a folding axis FX extending in a predetermined direction or in the direction of the second directional axis DR2. The folding area FA may have a curvature radius RD of about 5 millimeters (mm) or less.

In an embodiment, as shown in FIGS. 1 and 2, a single folding area FA may be defined between two non-folding areas NFA, but embodiments of the invention are not limited thereto. In one alternative embodiment, for example, the display device DD may include three or more plurality of non-folding areas NFA and a plurality of folding areas FA disposed between the non-folding areas NFA.

In an embodiment of the display device DD, the non-folding areas NFA may be symmetric to each other with respect to the folding area FA. However, embodiments of the invention are not limited thereto. In one alternative embodiment, for example, where the folding area FA is disposed between the non-folding areas NFA, two non-folding areas NFA, which face each other with respect to the folding area FA, may have different areas or sizes from each other.

The display surface DS of the display device DD may include a display area DA and a non-display area NDA disposed around the display area DA. The display area DA may display an image, and the non-display area NDA may not display an image. The non-display area NDA may surround the display area DA and define an edge of the display device DD.

Referring to FIG. 2, the display device DD may be a bendable (or foldable) display device that is capable of being folded or unfolded. In an embodiment, the display device DD may be folded as the folding area FA is bent with respect to the folding axis FX that is parallel to the second directional axis DR2. The folding axis FX may be defined as a minor axis that is parallel to the short side of the display device DD.

When the display device DD is in a folded state, the non-folding areas NFA may face each other, that is, the display device DD may be in-folded such that the display surface DS is not exposed to the outside. However, the embodiment of the invention is not limited thereto. In an alternative embodiment, the display device DD may be out-folded to expose the display surface DS to the outside.

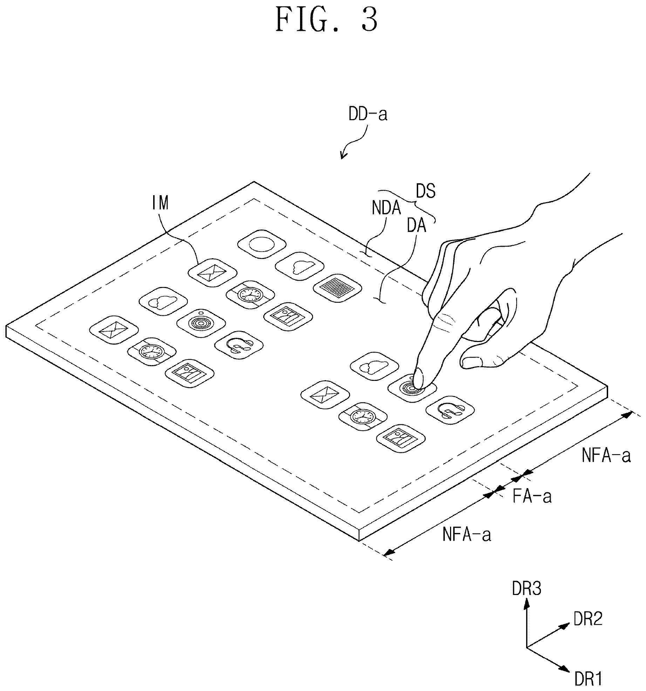

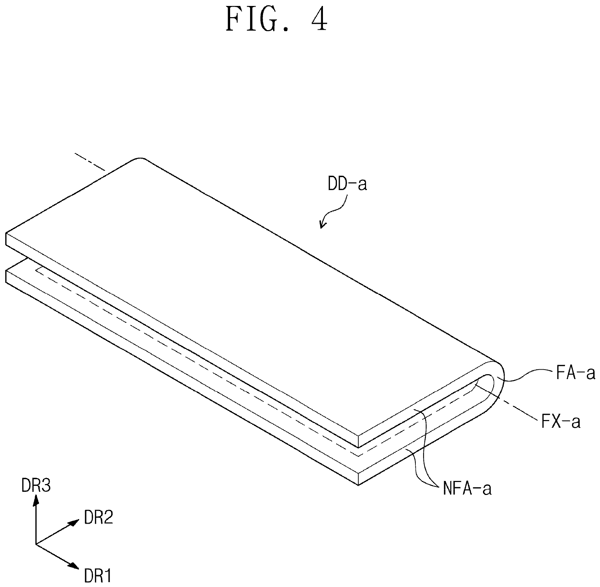

FIG. 3 is a perspective view illustrating a display device according to an embodiment of the invention. FIG. 4 is a view illustrating the display device of FIG. 3 in a folded state.

The display device DD-a in FIG. 3 may substantially have the same configuration as the display device DD in FIG. 1 except for the folding operation thereof. Thus, hereinafter, the folding operation of the display device DD-a in FIGS. 3 and 4 will be mainly described, and any repetitive detailed description of the same or like elements as those described above with reference to FIGS. 1 and 2 will be omitted or simplified.

Referring to FIGS. 3 and 4, an embodiment of the display device DD-a may include a folding area FA-a and a plurality of non-folding areas NFA-a. The folding area FA-a may be disposed between the non-folding areas NFA-a, and the folding area FA-a and the non-folding areas NFA-a may be disposed next to each other in the direction of the second directional axis DR2.

In such an embodiment, the display device DD-a may be folded as the folding area FA-a is bent with respect to a folding axis FX-a that is parallel to the first directional axis DR1. The folding axis FX-a may be defined as a major axis that is parallel to a long side of the display device DD-a. In an embodiment, as shown in FIG. 1, the display device DD may be folded with respect to the minor axis. Alternatively, as shown in FIG. 3, the display device DD-a may be folded with respect to the major axis. In an embodiment, the display device DD-a may be in-folded such that a display surface DS is not exposed to the outside as shown in FIG. 4, but embodiments of the invention are not limited thereto. In one alternative embodiment, for example, the display device DD-a may be out-folded while being folded with respect to the major axis.

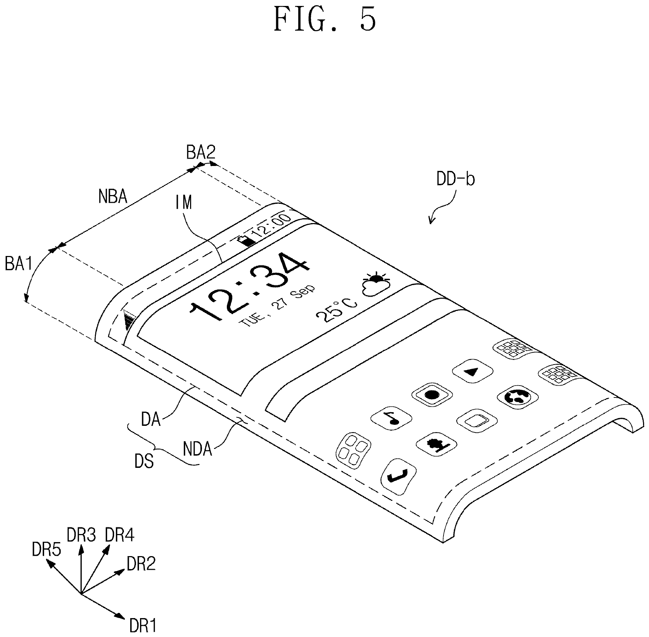

FIG. 5 is a perspective view illustrating a display device according to an embodiment of the invention. A display device DD-b according to an embodiment may include a bending area BA1 and BA2 and a non-bending area NBA, and the bending area BA1 and BA2 may be bent from one side of the non-bending area NBA.

Referring to FIG. 5, an embodiment of the display device DD-b may include a non-bending area NBA, in which the image IM is displayed, on a front surface and a first bending area BA1 and a second bending area BA2 in which the image IM is displayed on a side surface. The first bending area BA1 and the second bending area BA2 may be bent from opposing sides of the non-bending area NBA, respectively.

Referring to FIG. 5, the non-bending area NBA may provide the image IM in the direction of the third directional axis DR3, which is a direction of the front surface of the display device DD-b or a thickness direction of the non-bending area NBA, and the first bending area BA1 and the second bending area BA2 may provide the image in a direction of a fifth directional axis DR5 and in a direction of a fourth directional axis DR4, respectively. The fourth directional axis DR4 and the fifth directional axis DR5 may cross the first to third directional axes DR1, DR2, and DR3. However, the directions indicated by the first to fifth directional axes DR1 to DR5 are relative concept, and are not limited to a direction relationship in the drawings.

In an embodiment, the display device DD-b may be a bending display device including a non-bending area NBA and bending areas BA1 and BA2 disposed at opposing side of the non-bending area NBA, respectively. In an alternative embodiment, although not shown in the drawings, the display device may be a bending display device including one non-bending area and one bending area. In such an embodiment, the bending area may be bent only at a single side of the non-bending area.

Although an embodiment of the foldable display device and the bending display device are illustrated in FIGS. 1 to 5 and described with reference thereto, embodiments of the invention are not limited thereto. In an alternative embodiment, the display device may be a rollable display device, a flat rigid display device, or a bent rigid display device, for example.

Hereinafter, for convenience of description, embodiments where the display device DD is foldable with respect to the minor axis will be described in detail, but embodiments of the invention are not limited thereto. Features to be described hereinafter may be also applied to the display device DD-a foldable with respect to the major axis.

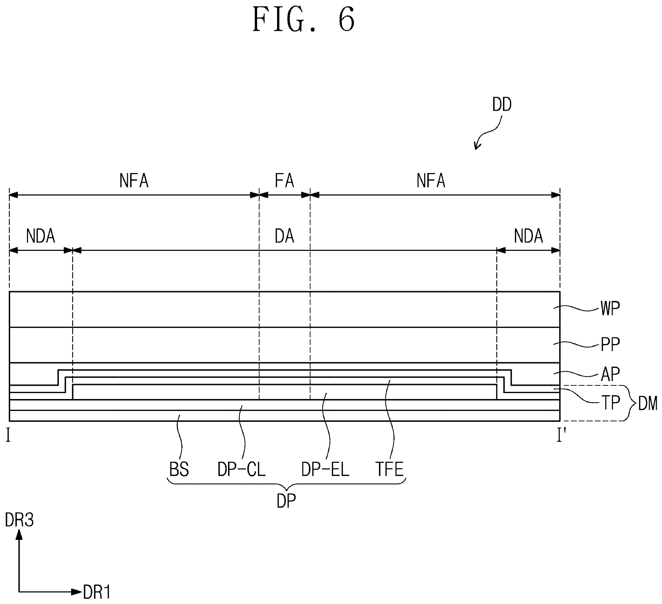

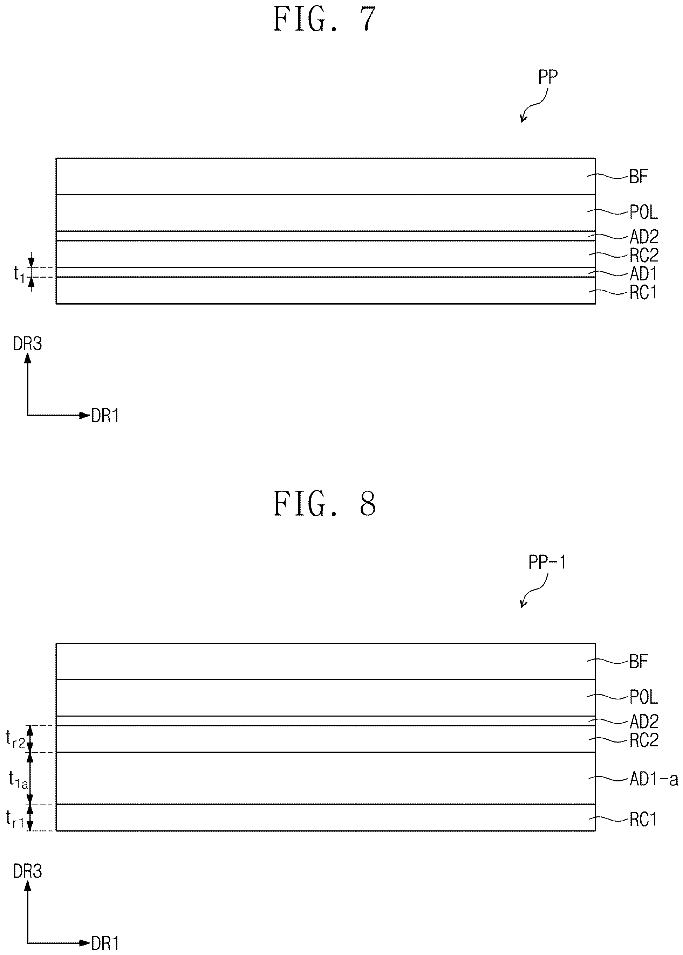

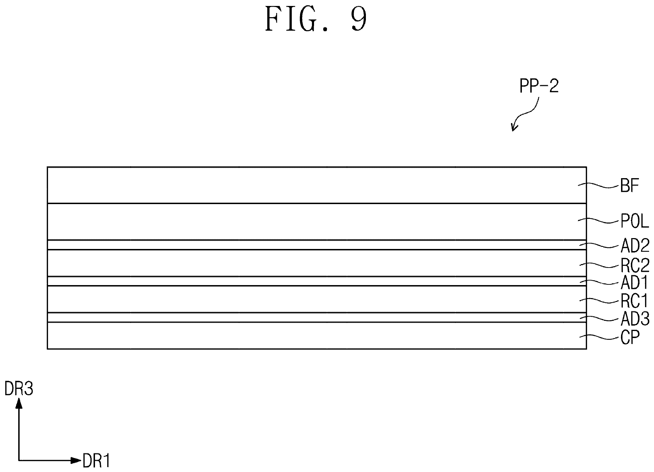

FIG. 6 is a cross-sectional view illustrating the display device DD according to an embodiment. FIG. 6 may be a cross-sectional view taken along line I-I' of FIG. 1. FIG. 7 is a cross-sectional view illustrating a polarizing plate PP according to an embodiment. FIG. 7 is a view illustrating an embodiment of the polarizing plate PP of the display device DD shown in FIG. 6. FIGS. 8 and 9 are cross-sectional views illustrating polarizing plates PP-1 and PP-2 according to an embodiment, respectively.

An embodiment of the display device DD may include a display module DM, a polarizing plate PP disposed on the display module DM, and a window panel WP disposed on the display module DM. The display module DM may include a display panel DP including a display element layer DP-EL and an input sensing part TP disposed on the display panel DP. The polarizing plate PP may be disposed on the input sensing part TP, and the window panel WP may be disposed on the polarizing plate PP.

The display device DD may further include an adhesive member AP disposed between the input sensing part TP and the polarizing plate PP. In an embodiment, although not illustrated in the drawing, the adhesive member may be also disposed between the polarizing plate PP and the window panel WP. In an embodiment, the adhesive member AP may be an optically clear adhesive film ("OCA") or an optically clear adhesive resin layer ("OCR").

The display panel DP may include a base substrate BS, a circuit layer DP-CL disposed on the base substrate BS, a display element layer DP-EL disposed on the circuit layer DP-CL, and an encapsulation layer TFE that covers the display element layer DP-EL.

The input sensing part TP may be disposed on the display panel DP. The input sensing part TP may be disposed directly on the encapsulation layer TFE of the display panel DP.

The input sensing part TP may detect an external input, convert the detected external input into a input signal corresponding thereto, and provide the input signal to the display panel DP. In an embodiment of the display device DD, the input sensing part TP may be a touch sensing part that detects a touch, for example. The input sensing part TP may recognize a direct touch of a user, an indirect touch of a user, a direct touch of an object, or an indirect touch of an object. In an embodiment, the input sensing part TP may detect at least one of a position and an intensity (pressure) of a touch applied from an outside. Embodiments of the input sensing part TP may have various structures or include various materials, and embodiments of the invention are not limited to a particular structure or material. The input sensing part TP may include a plurality of sensing electrodes (not shown) for detecting an external input. The sensing electrodes (not shown) may detect an external input in a capacitance method. The display panel DP may receive an input signal from the input sensing part TP and generate an image corresponding to the input signal.

The window panel WP may protect the display panel DP, the input sensing part TP, and the like. The image IM displayed on the display panel DP may be visible through the window panel WP and be provided to a user. The window panel WP may provide or define a touch surface of the display device DD. The window panel WP of the display device DD including the folding area FA may be a flexible window.

The window panel WP may include a plastic film. The window panel WP may have a multilayer structure. The window panel WP may have a multilayer structure including layers, each of which is selected from at least one of a glass substrate, a plastic film and a plastic substrate. The window panel WP may further include a bezel pattern. The multilayer structure may be provided or formed through a continuous process or an adhesion process using an adhesive layer.

In an alternative embodiment, the window panel WP shown in FIG. 6 may be omitted from the display device.

The polarizing plate PP may effectively prevent reflection of external light. The polarizing plate PP may block a portion of external light. The polarizing plate PP may perform an antireflection function or a reflection preventing function of minimizing reflection caused by external light in the display device DD.

Referring to FIG. 7, an embodiment of the polarizing plate PP may include a first phase retardation layer RC1, a second phase retardation layer RC2, a polarizer layer POL, a first adhesive member AD1, and a second adhesive member AD2. In an embodiment, the polarizing plate PP may further include a base film BF.

The base film BF may be a member or an element that provides or defines a base surface, on which the polarizer layer POL, the phase retardation layers RC1 and RC2, and the like are disposed. In an embodiment of the display device DD, the base film BF of the polarizing plate PP may be disposed closer to the window panel WP than the polarizer layer POL and the phase retardation layers RC1 and RC2.

The base film BF may include or be made of a polymer material. In one embodiment, for example, the base film BF may include or be made of at least one selected from polyimide, polyacrylate, polymethylmethacrylate ("PMMA"), polycarbonate ("PC"), polyethylenenaphthalate ("PEN"), polyvinylidene chloride, polyvinylidene difluoride ("PVDF"), polystyrene, ethylene vinylalcohol copolymer, and a combination thereof. However, embodiments of the invention are not limited to the above-described polymer materials as a material of the base film BF. In such embodiments, the base film BF may include at least one of all sorts of materials as long as each of the material has optical transparency capable of providing the image IM, which is provided from the display panel DP, to a user.

In an embodiment of the polarizing plate PP, the first phase retardation layer RC1, the second phase retardation layer RC2 and the polarizer layer POL are sequentially laminated or stacked one on another in the direction of the third directional axis DR3. In such an embodiment, the first adhesive member AD1 is disposed between the first phase retardation layer RC1 and the second phase retardation layer RC2, and the second adhesive member AD2 may be disposed between the second phase retardation layer RC2 and the polarizer layer POL. In an embodiment of the display device DD, the first phase retardation layer RC1 may be disposed closer to the display module DM than the polarizer layer POL.

In an embodiment of the polarizing plate PP according to the claimed invention, the first adhesive member AD1 is a pressure sensitive adhesive layer. In an embodiment of the polarizing plate PP, the first adhesive member AD1 may have a refractive index different from a refractive index of the second phase retardation layer RC2, where the difference therebetween is about 0.25 or less. The first and second adhesive members AD1 and AD2 will be described later in greater detail.

The polarizer layer POL may be a linear polarizer that is an optical layer that linearly polarizes light passing therethrough in a predetermined direction. The polarizer layer POL may be a film type linear polarizer including an elongated polymer film. In one embodiment, for example, the elongated polymer film may be an elongated polyvinylalchol-based film.

The polarizer layer POL may be manufactured by adsorbing a dichroic dye to the elongated polymer film. In one embodiment, for example, the polarizer layer POL may be manufactured by adsorbing iodine to the elongated polyvinylalchol-based film. In such an embodiment, a direction in which the polymer film is elongated may be an absorption axis of the polarizer layer POL, and a direction perpendicular to the elongated direction may be a transmission axis of the polarizer layer POL.

Although not shown in the drawing, the polarizer layer POL may further include a protection layer. In one embodiment, for example, a triacetyl cellulose ("TAC") layer may be further provided on at least one of top and bottom surfaces of the polarizer layer POL. However, embodiments of the invention are not limited thereto. In one embodiment, for example, the polarizer layer POL may further include, as a protection layer, a hard coating layer, an anti-reflection layer or an anti-glare layer.

The polarizing plate PP may include the first phase retardation layer RC1 and the second phase retardation layer RC2, which are disposed below the polarizer layer POL. The second phase retardation layer RC2 may be disposed above the first phase retardation layer RC1.

The first phase retardation layer RC1 may be an optical layer that retards a phase of light passing therethrough. The first phase retardation layer RC1 may be a $\lambda/4$ phase retardation layer. In one embodiment, for example, when light, which is transmitted through the polarizer layer POL and provided to the first phase retardation layer RC1, has a wavelength of about 550 nanometers (nm), the light transmitted through the first phase retardation layer RC1 may have a phase retardation value of about 137.5 nm.

In an embodiment, the first phase retardation layer RC1 has an optical anisotropy to convert a polarization state of light incident thereinto. In such an embodiment, the light, which is transmitted through the polarizer layer POL and provided to the first phase retardation layer RC1, may be converted from a linear polarization state to a circular polarization state. In such an embodiment, light provided to the first phase retardation layer RC1 in a circular polarization state may be converted to a linear polarization state.

In an embodiment of the polarizing plate PP, the second phase retardation layer RC2 may be disposed between the first phase retardation layer RC1 and the polarizer layer POL. The second phase retardation layer RC2 may be an optical layer that retards a phase of light passing therethrough by $\lambda/2$. In one embodiment, for example, when light, which is transmitted through the polarizer layer POL and provided to the second phase retardation layer RC2, has a wavelength of about 550 nm, the light transmitted through the second phase retardation layer RC2 may have a phase retardation value of about 275 nm.

In an embodiment, the second phase retardation layer RC2 may convert a polarization state of incident light. A polarization direction of linearly polarized light incident from the polarizer layer POL to the second phase retardation layer RC2 may be changed.

In an embodiment, one of the phase retardation value in a thickness direction of the first phase retardation layer RC1 and the phase retardation value in a thickness direction of the second phase retardation layer RC2 may have a positive value, and the other of the phase retardation value in the thickness direction of the first phase retardation layer RC1 and the phase retardation value in the thickness direction of the second phase retardation layer RC2 may have a negative value. In one embodiment, for example, the first phase retardation layer RC1 may be a positive A-plate, and the second phase retardation layer RC2 may have a negative A-plate.

In an embodiment of the polarizing plate PP, each of the first phase retardation layer RC1 and the second phase retardation layer RC2 may be a liquid crystal coating layer. Each of the first phase retardation layer RC1 and the second phase retardation layer RC2 may be a liquid crystal coating layer including or made by using a reactive liquid crystal monomer. The first phase retardation layer RC1 and the second phase retardation layer RC2 may be manufactured through a process in which the reactive liquid crystal monomer is applied, oriented, and polymerized. In one embodiment, for example, the liquid crystal monomer used for the first phase retardation layer RC1 may have a bar-type nematic phase, and the liquid crystal monomer used for the second phase retardation layer RC2 may have a disc-type discotic phase. In such an embodiment, the first phase retardation layer RC1 may be a nematic liquid crystal coating layer, and the second phase retardation layer RC2 may be a discotic liquid crystal coating layer.

Each of the first phase retardation layer RC1 and the second phase retardation layer RC2 may include only a liquid crystal layer without a base substrate that is a support body. In such an embodiment, the first phase retardation layer RC1 and the second phase retardation layer RC2, each of which includes only the liquid crystal coating layer without including the base substrate, are used, such that a total thickness of the display device DD (refer to FIG. 6) may be reduced. In such an embodiment, a thickness of the polarizing plate PP may be reduced by using the first phase retardation layer RC1 and the second phase retardation layer RC2, which are liquid crystal coating layers, and thus the display device DD may be further easily folded or bent.

In an embodiment, each of the first phase retardation layer RC1 and the second phase retardation layer RC2, which are liquid crystal coating layers, may have a refractive index in a range from about 1.55 to about 1.88. In one embodiment, for example, each of the first phase retardation layer RC1 and the second phase retardation layer RC2 may have a refractive index in a range from about 1.6 to about 1.8. The first phase retardation layer RC1 and the second phase retardation layer RC2 may have a same refractive index as or different refractive indexes from each other.

The polarizing plate PP may include the first adhesive member AD1 disposed between the first phase retardation layer RC1 and the second phase retardation layer RC2. In an embodiment of the polarizing plate PP, the first adhesive member AD1 may be an adhesive layer having a refractive index different from a refractive index of the second phase retardation layer RC2, where the difference therebetween is about 0.25 or less. The first adhesive member AD1, not according to the claimed invention, may be an adhesive layer having a glass transition temperature (Tg) in a range from about 40°C to about 150°C. In such an embodiment, the adhesive layer has a glass transition temperature greater than a room temperature, such that the adhesive member is not sticky in the room temperature.

The adhesive layer may include or be made of an adhesive composition including at least one of an acrylic-based resin, a silicon-based resin, a urethane-based resin, or an epoxy-based resin. In one embodiment of the polarizing plate PP, for example, the first adhesive member AD1 may be an adhesive layer having a glass transition temperature in a range from about 40°C to about 150°C.

The first adhesive member AD1 including the adhesive layer having a glass transition temperature in a range from about 40°C to about 150°C may have a refractive index different from the refractive index of the second phase retardation layer RC2 by about 0.25 and may have a thickness $t_1$ in a range from about 0.1 $\mu$m to about 2 $\mu$m. The first adhesive member AD1 may have a refractive index in a range from about 1.5 to about 1.8, and have a refractive index difference different from a refractive index of each of the adjacent phase retardation layers RC1 and RC2 by about 0.25.

In an embodiment of the polarizing plate PP not according to the claimed ivention, the first phase retardation layer RC1 may have a refractive index equal to or greater than a refractive index of the first adhesive member AD1, and the second phase retardation layer RC2 may have a refractive index greater than the refractive index of the first adhesive member AD1. In an embodiment not according to the claimed invention, the first phase retardation layer RC1 may have a refractive index less than a refractive index of the first adhesive member AD1, and a refractive index difference between the first phase retardation layer RC1 and the first adhesive member AD1 may be about 0.25 or less.

In an embodiment of the polarizing plate PP not according to the claimed invention, where the first adhesive member AD1 is an adhesive layer having a glass transition temperature in a range from about 40°C to about 150°C, the first and second phase retardation layers RC1 and RC2 and the first adhesive member AD1 may satisfy Inequation 1 below. In Inequation 1, nRC1 and nRC2 denote refractive indexes of the first and second phase retardation layers RC1 and RC2, respectively, and nAD1 denote a refractive index of the first adhesive member AD1.

## [Inequation 1]

$$nRC1, nRC2 \geq nAD1$$

When relationship of inequation 1 is satisfied, a refractive index difference between the second phase retardation layer RC2 and the first adhesive member AD1 is about 0.25 or less.

In an embodiment of the polarizing plate PP not according to the claimed invention, where the first adhesive member AD1 is an adhesive layer, and the first phase retardation layer RC1 has a refractive index less than a refractive index of the first adhesive member AD1, and a refractive index difference between the first phase retardation layer RC1 and the first adhesive member AD1 may be about 0.25 or less.

In an embodiment, when external light is provided to the polarizing plate, since a reflection light interference phenomenon occur to a great degree when light, which is incident in a direction from an upper portion to a lower portion of the polarizing plate PP, is incident from a high refractive medium to a low refractive medium, a refractive index difference between the second phase retardation layer RC2 and the first adhesive member AD1 is desired to be about 0.25 or less in a case where the second phase retardation layer RC2 has a refractive index greater than a refractive index of the first adhesive member AD1. In such an embodiment, even when the first phase retardation layer RC1 has a refractive index less than a refractive index of the first adhesive member AD1, a refractive index difference between the first phase retardation layer RC1 and the first adhesive member AD1 is desired to be maintained to be about 0.25 or less.

The adhesive layer used as the first adhesive member AD1 may be cross-linked through an ultraviolet ("UV") curing or thermal curing process. The first adhesive member AD1 may be an adhesive layer including at least one of an acrylic-based resin, a silicon-based resin, a urethane-based resin, or an epoxy-based resin, for example.

The first adhesive member AD1 may include an UV-curable adhesive. The first adhesive member AD1 may be an adhesive layer that is polymerized and cured through a radical polymerization reaction or a cationic polymerization reaction.

When the first adhesive member AD1 is an adhesive layer that is cross-linked by heat or ultraviolet rays, a thickness of the adhesive layer provided by curing an adhesive composition is limited, and thus an effect of cancelling an interference phenomenon of light reflected at the adhesive layer and adjacent optical layers by providing a great thickness of the adhesive layer may not be effectively exhibited. That is, if a refractive index difference between the phase retardation layers RC1 and RC2 and the first adhesive member AD1 is greater than about 0.25, mura phenomenon may be seen or perceived by the interference phenomenon of light reflected at the phase retardation layers RC1 and RC2 and the first adhesive member AD1.

In an embodiment not according to the claimed invention, where the first adhesive member AD1 of the polarizing plate PP is an adhesive layer that is cross-linked by heat or ultraviolet rays, the first adhesive member AD1 has a thickness $t_1$ in a range from about 0.1 $\mu$m to about 2 $\mu$m, and a refractive index difference between the second phase retardation layer RC2 and the first adhesive member AD1 is maintained to be about 0.25 or less. In such an embodiment, a refractive index difference between the first adhesive member AD1 and each of the phase retardation layers RC1 and RC2, which are optical layers adjacent thereto, may be maintained to be about 0.25 or less. Thus, in such an embodiment, the interference phenomenon of light reflected at the phase retardation layers RC1 and RC2 and the first adhesive member AD1 is minimized, such that a mura phenomenon in the polarizing plate PP may be effectively prevented or minimized. In such an embodiment, the display device DD may exhibit improved display quality by including the above-described polarizing plate PP.

In an embodiment not according to the claimed invention, where an adhesive layer having a glass transition temperature characteristic higher than a room temperature is used as the first adhesive member AD1, a coupling strength between the first phase retardation layer RC1 and the second phase retardation layer RC2 may increase. In such an embodiment, as the first adhesive member AD1 includes an adhesive layer having a high glass transition temperature, a deformation that may occur when the first adhesive member AD1 is folded or bent under the room temperature or high temperature may be minimized, and a deformation of the phase retardation layers RC1 and RC2 disposed adjacent to the first adhesive member AD1 may be minimized.

The adhesive layer of the first adhesive member AD1 may include or be made of an adhesive composition including a cationic polymerization compound. In one embodiment, for example, the adhesive composition may include at least one of an epoxy compound, a vinyl ether compound, an oxetane compound, an oxolane compound, a cyclic acetal compound, a cyclic lactone compound, a thiirane compound, a thio vinyl ether compound, a spiroorthoester compound, an unsaturated ethylene compound, a cyclic ether compound, and a cyclic thioether compound.

In an embodiment, the adhesive layer of the first adhesive member AD1 may include or be made of an adhesive composition including a radical polymerization compound containing a radical polymerization reactive radical. In one embodiment, for example, the radical polymerization compound may be an acrylic-based compound, and more particularly, a methacrylate compound.

The adhesive layer of the first adhesive member AD1 may include an acrylic-based compound having an aromatic ring, a halogen-based compound, a metallic oxide, a metallic chelate compound, an inorganic material, or inorganic nano-particles. The above-described acrylic-based compound having an aromatic ring, the halogen-based compound, the metallic oxide, the metallic chelate compound, the inorganic material, or the inorganic nano-particles may be used to increase a refractive index of the first adhesive member AD1. The adhesive layer of the first adhesive member AD1 may have a refractive index in a range from about 1.5 to about 1.8.

The acrylic-based compound having an aromatic ring in the adhesive layer may not include halogen atoms. In one embodiment, for example, the acrylic-based compound having an aromatic ring may be phenol ethoxylated acrylate, bisphenol A ethoxylated acrylate, phenoxy benzyl acrylate, 1-ethoxylated-o-phenylphenol acrylate, phenylthioethyl acrylate, bis(methacryloythiophenyl)sulfide, benzyl acrylate, urethane acrylate, or bisphenol epoxy diacrylate.

In one embodiment, for example, the halogen-based compound in the adhesive layer may be 2-chlorostyrene, 2,6-dichlorostyrene, pentabromophenyl acrylate, pentabromobenzyl acrylate, or chlorinated isobornyl acrylate.

In an embodiment, the adhesive layer may include zirconium acrylate, zirconium carboxyehtyl acrylate, or the like to adjust a refractive index.

In an embodiment, the adhesive composition of the first adhesive member AD1 may include a photo initiator. In an embodiment, the adhesive composition may further include an additive known in the art such as an optical sensitizing agent, a silane coupling agent, a plasticizer, and an antifoamer, for example, in addition to the initiator.

In an embodiment, the first adhesive member AD1 may have a thickness $t_1$ in a range from about 0.5 $\mu$m to about 2 $\mu$m. If the first adhesive member AD1 has a thickness $t_1$ less than about 0.1 $\mu$m, an adhesion strength for coupling the first phase retardation layer RC1 and the second phase retardation layer RC2 to each other may not be achieved, and thus delamination of the first adhesive member AD1 occur when the display device is folded or bent. Also, if the first adhesive member AD1 has a thickness $t_1$ greater than about 2 $\mu$m, a thickness reduction effect of the polarizing plate PP may not be sufficiently achieved, and a crack may occur in the phase retardation layers RC1 and RC2 disposed adjacent to the first adhesive member AD1 under a high temperature reliability condition.

In an embodiment, the polarizing plate PP may further include a second adhesive member AD2. The second adhesive member AD2 may be disposed between the second phase retardation layer RC2 and the polarizer layer POL. The second adhesive member AD2 may be a pressure sensitive adhesive layer having a glass transition temperature in a range from about -45°C to about 0°C or an adhesive layer having a glass transition temperature in a range from about 40°C to about 150°C. The second adhesive member AD2 may have a refractive index less than a refractive index of the second phase retardation layer RC2. However, the embodiment of the invention is not limited thereto. In one embodiment, for example, a refractive index difference between the second adhesive member AD2 and the second phase retardation layer RC2 may be about 0.25 or less. In an embodiment, where the second adhesive member AD2 is an adhesive layer, the adhesive layer may be the same as or different from the adhesive layer applied to the first adhesive member AD1.

FIG. 8 is a cross-sectional view illustrating a polarizing plate PP-1 according to an alternative embodiment. FIG. 8 exemplarily illustrates an embodiment of the polarizing plate PP-1 including a first adhesive member AD1-a having a greater thickness than the thickness of an embodiment of the polarizing plate PP described above with reference to FIG. 7.

In an embodiment, as shown in FIG. 8, the polarizing plate PP-1 may include: a first phase retardation layer RC1, a second phase retardation layer RC2 disposed on the first phase retardation layer RC1, a polarizer layer POL disposed on the second phase retardation layer RC2, and a first adhesive member AD1-a disposed between the first phase retardation layer RC1 and the second phase retardation layer RC2. In such an embodiment according to the claimed invention, the first adhesive member AD1-a is a pressure sensitive adhesive layer having a thickness $t_{1a}$ in a range from about 2 $\mu$m to about 10 $\mu$m. In such an embodiment, the first adhesive member AD1-a is a pressure sensitive adhesive layer having a glass transition temperature in a range from about - 45°C to about 0°C.

Each of the first phase retardation layer RC1 and the second phase retardation layer RC2 may have a thickness $t_{r1}$ or $t_{r2}$ in a range from about 0.5 $\mu$m to about 5 $\mu$m. In an embodiment, each of the first phase retardation layer RC1 and the second phase retardation layer RC2 may have a thickness $t_{r1}$ or $t_{r2}$ in a range from about 0.5 $\mu$m to about 2 $\mu$m. In such an embodiment, the thickness $t_{r1}$ of the first phase retardation layer RC1 may be the same as or different from the thickness $t_{r2}$ of the second phase retardation layer RC2. If each of the first phase retardation layer RC1 and the second phase retardation layer RC2 has a thickness $t_{r1}$ and $t_{r2}$ less than about 0.5 $\mu$m, optical characteristics may be ununiform or irregular in the phase retardation layer. Also, if each of the first phase retardation layer RC1 and the second phase retardation layer RC2 has a thickness $t_{r1}$ and $t_{r2}$ greater than about 5 $\mu$m, the thickness reduction effect of the polarizing plate PP may not be sufficient. That is, when each of the first phase retardation layer RC1 and the second phase retardation layer RC2 has a thickness $t_{r1}$ and $t_{r2}$ greater than about 5 $\mu$m, a wrinkle or a crack may occur in the phase retardation layers RC1 and RC2 under a folding or bending condition.

In an embodiment of the polarizing plate PP-1 shown in FIG. 8, the first adhesive member AD1-a, which is a pressure sensitive adhesive layer, has a thickness $t_{1a}$ in a range from about 2 $\mu$m to about 10 $\mu$m, and the thickness $t_{1a}$ of the first adhesive member AD1-a may be greater than the thickness $t_{r1}$ and $t_{r2}$ of each of the first phase retardation layer RC1 and the second phase retardation layer RC2.

In an embodiment of the polarizing plate PP-1, the first adhesive member AD1-a has a relatively great thickness of about 2 $\mu$m or greater, such that the interference phenomenon of light reflected at the phase retardation layers RC1 and RC2 and the first adhesive member AD1-a may be minimized, thereby effectively preventing a mura phenomenon in the polarizing plate PP-1 as an interference phenomenon of light reflected at the optical layers is cancelled in the pressure sensitive adhesive layer.

In an embodiment, where the first adhesive member AD1-a is a pressure sensitive adhesive layer, a refractive index difference between the second phase retardation layer RC2 and the first adhesive member AD1-a may be about 0.25 or less. In an embodiment, the polarizing plate PP-1 may have a thickness in a range from about 2 $\mu$m to about 10 $\mu$m and include the first adhesive member AD1-a, which is the pressure sensitive adhesive layer having a refractive index different from a refractive index of the second phase retardation layer RC2 by about 0.25 or less, to minimize the light interference phenomenon generated from the phase retardation layers RC1 and RC2 and the first adhesive member AD1-a, thereby exhibiting further improved optical characteristics. In an embodiment, the display device DD may exhibit improved display quality by including the polarizing plate PP-1.

The pressure sensitive adhesive layer used as the first adhesive member AD1-a may include or be made of an adhesive composition including at least one of an acrylic-base adhesive, a silicon-based adhesive, an epoxy-based adhesive, or a rubber-based adhesive. The adhesive composition may further include an additive well-known in the art such as a silane coupling agent, a tackifier resin, a hardener, a UV stabilizer, an antioxidant, and a filling agent, for example.

In an embodiment, each of the adhesive layer having a glass transition temperature in a range from about 40°C to about 150 °C and the pressure sensitive adhesive layer having a glass transition temperature in a range from about -45°C to about 0 °C may include or be made of an acrylic-based compound. Alternatively, the adhesive layer and the pressure sensitive adhesive layer may be adhesive members having different degrees of polymerization or different degree of cross-linking from each other.

In such an embodiment of the polarizing plate PP-1 shown in FIG. 8, a base film BF, a polarizer layer POL, a first phase retardation layer RC1, a second phase retardation layer RC2, and a second adhesive member AD2 are substantially the same as those described above with reference to FIG. 7, and any repetitive detailed description thereof will be omitted.

FIG. 9 is a cross-sectional view illustrating a polarizing plate according to another alternative embodiment.

Referring to FIG. 9, an embodiment of a polarizing plate PP-2 may further include a light compensation layer CP as an optical layer. The light compensation layer CP may be disposed on a bottom surface of a first phase retardation layer RC1. In an embodiment of the display device, the light compensation layer CP may be disposed adjacent to the display module DM. In an embodiment, the polarizing plate PP-2 may include optical layers such as a light compensation layer CP, a first phase retardation layer RC1, a second phase retardation layer RC2, and a polarizer layer POL, which are sequentially laminated one on another in the direction of the third directional axis DR3. Adhesive members AD1, AD2, and AD3 may be provided between the optical layers.

A base film BF, a polarizer layer POL, a first phase retardation layer RC1, a second phase retardation layer RC2, and a second adhesive member AD2 in the polarizing plate PP-2 of FIG. 9 are substantially the same as those of the polarizing plate PP described above with reference to FIG. 7, and any repetitive detailed descriptions thereof will be omitted.

In an embodiment of the polarizing plate PP-2, as shown in FIG. 9, the first adhesive member AD1 may be an adhesive layer having a refractive index different from a refractive index of the second phase retardation layer RC2 by about 0.25 or less, or a pressure sensitive adhesive layer having a thickness in a range from about 2 $\mu$m to about 10 $\mu$m. In an embodiment, where the first adhesive member AD1 of the polarizing plate PP-2 is the adhesive layer, the adhesive layer may be substantially the same as the adhesive layer described above with reference to FIG. 7. In an embodiment, where the first adhesive member AD1 of the polarizing plate PP-2 is the pressure sensitive adhesive layer, the pressure sensitive adhesive layer may be substantially the same as the pressure sensitive adhesive layer described above with reference to FIG. 8.

In an embodiment of the polarizing plate PP-2, the light compensation layer CP may be an optical layer that compensates a phase retardation value in a thickness direction of the phase retardation layers RC1 and RC2. In one embodiment, for example, the light compensation layer CP may be an optical layer that compensates a phase retardation value in a thickness direction of the first phase retardation layer RC1.

The light compensation layer CP may be a C-plate. The C-plate may be a negative C-plate or a positive C-plate. The light compensation layer CP may be a type of a solidified layer or a cured layer of a liquid crystal composition including a liquid crystal compound. Alternatively, the light compensation layer CP may be a film type.

A third adhesive member AD3 may be disposed between the light compensation layer CP and the first phase retardation layer RC1. The third adhesive member AD3 may be a pressure sensitive adhesive layer having a glass transition temperature in a range from about -45°C to about 0°C or an adhesive layer having a glass transition temperature in a range from about 40°C to about 150°C. Other features of the third adhesive member AD3 may be substantially the same as those of the second adhesive member AD2 described above with reference to FIG. 2, and any repetitive detailed description thereof will be omitted.

An embodiment of the polarizing plate, as described above with reference to FIGS. 7 to 9, may minimize a mura phenomenon caused by an interference phenomenon of reflected light generated by the phase retardation layers and the adhesive member, by including an adhesive member that is an adhesive layer disposed between phase retardation layers and being a pressure sensitive adhesive layer having a thickness in a range from about 2 $\mu$m to 10 $\mu$m, which is greater than the thickness of the phase retardation layer.

Referring back to FIG. 6, an embodiment of the display device DD may include the display panel DP disposed below the polarizing plate PP.

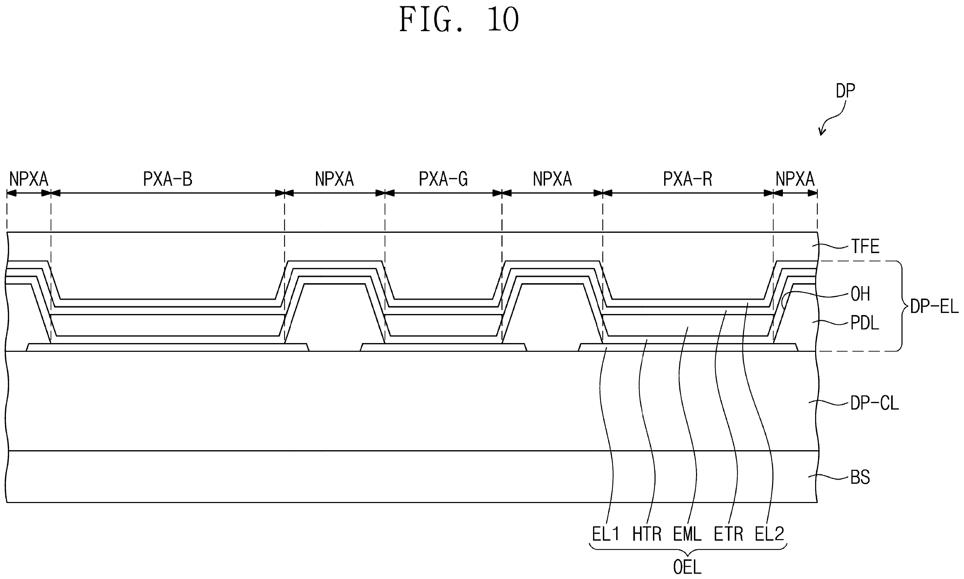

FIG. 10 is a cross-sectional view illustrating the display panel DP according to an embodiment.

In an embodiment, the display panel DP of the display device DD may be a light emitting display panel. In one embodiment, for example, the display panel DP may be an organic electroluminescent display panel or a quantum dot light emitting display panel. However, embodiments of the invention are not limited thereto.

Referring to FIGS. 6 and 10, the display panel DP may include a light emitting element OEL, and the polarizing plate PP may be disposed on the display panel DP. In an embodiment, the display panel DP may include a base substrate BS, a circuit layer DP-CL and a display element layer DP-EL, which are provided on the base substrate BS, and an encapsulation layer TFE disposed on the display element layer DP-EL. In such an embodiment, the base substrate BS, the circuit layer DP-CL, the display element layer DP-EL, and the encapsulation layer TFE may be sequentially laminated one on another in the direction of the third directional axis DR3.

The display element layer DP-EL may include a pixel defining layer PDL and a plurality of light emitting elements OEL disposed on an opening OH defined in the pixel defining layer PDL.

The base substrate BS may provide a base surface on which the display element layer DP-EL is disposed. The base substrate BS may be a glass substrate, a metal substrate, or a plastic substrate. However, embodiments of the invention are not limited thereto. In one embodiment, for example, the base substrate BS may be an inorganic layer, an organic layer, or a composite material layer.

In an embodiment, the circuit layer DP-CL may be disposed on the base substrate BS, and the circuit layer DP-CL may include a plurality of transistors (not shown). Each of the transistors (not shown) may include a control electrode, an input electrode, and an output electrode. In one embodiment, for example, the circuit layer DP-CL may include a switching transistor and a driving transistor, which are for driving the light emitting elements OEL of the display element layer DP-EL.

The pixel defining layer PDL may include or be made of a polymer resin. In one embodiment, for example, the pixel defining layer PDL may include a polyacrylate-based resin or a polyimide-based resin. In an embodiment, the pixel defining layer PDL may further include an inorganic material in addition to the polymer resin. In an embodiment, the pixel defining layer PDL may include a light absorbing material, a black pigment, or a black dye. In an embodiment, the pixel defining layer PDL may include or be made of an inorganic material. In one embodiment, for example, the pixel defining layer PDL may include silicon nitride (SiNx), silicon oxide (SiOx), silicon oxynitride (SiOxNy), or the like. The pixel defining layer PDL may define light emitting areas PXA-B, PXA-G, and PXA-R. The light emitting areas PXA-B, PXA-G, and PXA-R and a non-light emitting area NPXA may be defined or distinguished by the pixel defining layer PDL.

The plurality of light emitting elements OEL, which are distinguished by the pixel defining layer PDL, may emit light in wavelength regions different from each other. However, embodiments of the invention are not limited thereto. In one embodiment, for example, the light emitting elements OEL, which are spaced apart from each other, may emit light in a same wavelength region as each other or emit light in different wavelength regions from each other.

In an embodiment, the light emitting element OEL may include a first electrode EL1, a second electrode EL2, and a light emitting layer EML disposed between the first electrode EL1 and the second electrode EL2. In an embodiment, the light emitting element OEL may include a hole transporting region HTR disposed between the first electrode EL1 and the light emitting layer EML and an electron transporting region ETR disposed between the light emitting layer EML and the second electrode EL2. The hole transporting region HTR may include a hole injection layer disposed adjacent to the first electrode EL1 and a hole transporting layer disposed between the hole injection layer and the light emitting layer EML, and the electron transporting region ETR may include an electron injection layer disposed adjacent to the second electrode EL2 and an electron transporting layer disposed between the light emitting layer EML and the electron injection layer.

The light emitting layer EML may have a single layer structure made of a single material, a single layer structure made of a plurality of materials, which are different from each other, or a multi-layer structure including a plurality of layers made of a plurality of materials, respectively, which are different from each other.

In an embodiment, where the display panel DP of the display device DD is an organic electroluminescent display panel, the light emitting layer EML may include anthracene derivatives, pyrene derivatives, fluoranthene derivatives, chrysene derivatives, dihydro-benzanthracene derivatives, or triphenylene derivatives. In one embodiment, for example, the light emitting layer EML may include anthracene derivatives or pyrene derivatives.

In an embodiment, where the display panel DP is an organic electroluminescent display panel, the light emitting layer EML may include a host and a dopant. In one embodiment, for example, the light emitting layer EML may include, as a host material, at least one of bis[2-(diphenylphosphino)phenyl] ether oxide ("DPEPO"), 4,4'-bis(carbazol-9-yl)biphenyl ("CBP"), 1,3-bis(carbazol-9-yl)benzene ("mCP"), 2,8-bis(diphenylphosphoryl)dibenzo[b,d]furan ("PPF"), 4,4',4"-tris(carbazol-9-yl)-triphenylamine ("TCTA"), and 1,3,5-tris(N-phenylbenzimidazole-2-yl)benzene ("TPBi"). However, embodiments of the invention are not limited thereto. In one embodiment, for example, tris(8-hydroxyquinolino)aluminum ("Alq3"), CBP, poly(N-vinylcarbazole) ("PVK"), 9,10-di(naphthalene-2-yl)anthracene ("ADN"), TCTA, TPBi, 3-tert-butyl-9,10-di(naphth-2-yl)anthracene ("TBADN"), distyrylarylene ("DSA"), 4,4'-bis(9-carbazolyl)-2,2'-dimethyl-biphenyl ("CDBP"), 2-methyl-9,10-bis(naphthalen-2-yl)anthracene ("MADN"), hexaphenyl cyclotriphosphazene ("CP1"), 1,4-bis(triphenylsilyl)benzene ("UGH2"), hexaphenylcyclotrisiloxane ("DPSiO3"), octaphenylcyclotetra siloxane ("DPSiO4"), or PPF may be used as a host material.

In an embodiment, the light emitting layer EML may include, as a dopant material, styrene derivatives (e.g., 1, 4-bis[2-(3-N-ethylcarbazoryl)vinyl]benzene ("BCzVB"), 4-(di-p-tolylamino)-4'-[(di-p-tolylamino)styryl]stilbene ("DPAVB"), N-(4-((E)-2-(6-((E)-4-(diphenylamino)styryl)naphthalen-2-yl)vinyl)phenyl)-N-phenylbenzenamine ("N-BDAVBi")), perylene and derivatives thereof (e.g., 2, 5, 8, 11-Tetra-t-butylperylene ("TBP")), pyrene and derivatives thereof (e.g., 1, 1-dipyrene, 1, 4-dipyrenylbenzene, 1, 4-bis(n, n-diphenylamino)pyrene).

In an embodiment, where the display panel DP is a quantum dot light emitting display panel, the display panel DP may include a quantum dot material in the light emitting layer EML. A core of the quantum dot may include at least one selected Group II-VI compound, Group III-V compound, Group IV-VI compound, Group IV element, Group IV compound, and a combination thereof.

The Group II-VI compound may include as least one selected from the group consisting of a binary compound selected from the group consisting of CdSe, CdTe, CdS, ZnS, ZnSe, ZnTe, ZnO, HgS, HgSe, HgTe, MgSe, MgS, and a combination thereof, a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a combination thereof, and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and a combination thereof.

The III-V compound may include as least one selected from the group consisting of: a binary compound selected from the group consisting of GaN, GaP, GaAs, GaSb, AlN, AlP, AlAs, AlSb, InN, InP, InAs, InSb, and a combination thereof; a ternary compound selected from the group consisting of GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and a combination thereof; and a quaternary compound selected from the group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a combination thereof.

The IV-VI compound may include as least one selected from the group consisting of: a binary compound selected from the group consisting of SnS, SnSe, SnTe, PbS, PbSe, PbTe, and a combination thereof; a ternary compound selected from the group consisting of SnSeS, SnSeTe, SnSTe, PbSeS, PbSeTe, PbSTe, SnPbS, SnPbSe, SnPbTe, and a combination thereof; and a quaternary compound selected from the group consisting of SnPbSSe, SnPbSeTe, SnPbSTe, and a combination thereof. The Group IV compound may include as least one selected from the group consisting of Si, Ge, and a combination thereof. The Group IV compound may include as least one a binary compound selected from the group consisting of SiC, SiGe, and a combination thereof.

In an embodiment, the binary compound, the ternary compound or the quaternary compound may exist in a particle with a uniform concentration or exist in a same particle while being divided in a state in which a concentration distribution is partially different. Alternatively, the quantum dot may have a core-shell structure in which a shell including one quantum dot material surrounds a core including another quantum dot material. An interface between the core and the shell may have a concentration gradient in which a concentration of an element existed in the shell gradually decreases in a direction toward a center thereof.

In an embodiment, the quantum dot may have the core-shell structure including a core having nanocrystal and a shell surrounding the core. The shell of the quantum dot may serve as a protection layer for maintaining semiconductor characteristics by preventing chemical degeneration of the core and/or a charging layer for applying electrophoretic characteristics to the quantum dot. The shell may have a single-layer structure or a multi-layer structure. An interface between the core and the shell may have a concentration gradient in which a concentration of an element existed in the shell gradually decreases in a direction toward a center thereof. In one embodiment, for example, the shell of the quantum dot may include a metallic or non-metallic oxide, a semiconductor compound, or a combination thereof.

In one embodiment, for example, the metallic or non-metallic oxide may include a binary compound such as $SiO_2$, $Al_2O_3$, $TiO_2$, $ZnO$, $MnO$, $Mn_2O_3$, $Mn_3O_4$, $CuO$, $FeO$, $Fe_2O_3$, $Fe_3O_4$, $CoO$, $Co_3O_4$, $NiO$ or a ternary compound such as $MgAl_2O_4$, $CoFe_2O_4$, $NiFe_2O_4$, $CoMn_2O_4$. However, embodiments of the invention are not limited thereto.

In an embodiment, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, and AlSb. However, embodiments of the invention are not limited thereto.

The quantum dot may have a full width at half maximum ("FWHM") of a light emitting wavelength spectrum, which is about 45 nm or less, desirably about 40 nm or less, more desirably about 30 nm or less. When the FWHM of the quantum dot is in the above-described range, a color purity or a color reproduction property may improve. In an embodiment, since light emitted through the above-described quantum dot is emitted in all directions, an optical viewing angle may improve.

Also, although the shape of the quantum dot is generally used in the related field, embodiments of the invention are not limited to the shape of the quantum dot. More particularly, the quantum dot may have a shape such as a globular shape, a pyramid shape, a multi-arm shape, or shapes of a nano-particle, a nano-tube, a nano-wire, a nano-fiber, or a nano-plate shaped particle of a cubic.

The quantum dot may adjust a color of light emitted according to a particle size, and thus the quantum dot may have various light emitting colors such as blue, red, and green.

The encapsulation layer TFE may be disposed on the light emitting element OEL, e.g., on the second electrode EL2. The encapsulation layer TFE may be directly disposed on the second electrode EL2. The encapsulation layer TFE may have a single-layer structure or a multi-layer structure including a plurality of layers laminated one on another.

The display panel DP may include a non-light emitting area NPXA and light emitting areas PXA-B, PXA-G, and PXA-R. Each of the light emitting areas PXA-B, PXA-G, and PXA-R may be an area through which light generated from each of the light emitting elements OEL, which are distinguished by the pixel defining layer PDL, is emitted. The light emitting areas PXA-B, PXA-G, and PXA-R may be spaced apart from each other on a plane.

The light emitting areas PXA-B, PXA-G, and PXA-R may be divided into a plurality of groups according to colors of light generated from the light emitting elements OEL. In an embodiment of the display panel DP, as shown in FIG. 10, three light emitting areas PXA-B, PXA-G, and PXA-R for emitting blue light, green light, and red light may be defined. However, embodiments of the invention are not limited thereto.

In an embodiment, the display device may include a polarizing plate disposed on the display panel. The polarizing plate may be disposed on the display panel to block a portion of light provided to the display panel from the outside of the display device. In such an embodiment, the polarizing plate may block a portion of light reflected in the display panel and heading toward the outside of the display device.

The polarizing plate PP, PP-1 or PP-2 described above with reference to FIGS. 7 to 9 may be used as the polarizing plate of the display device according to an embodiment. In such an embodiment, the display device may exhibit improved display quality by including the polarizing plate on the display panel.

Table 1 below shows results obtained by evaluating whether mura phenomenon is seen or perceived in the display device. The evaluation is performed by naked eyes, and embodiments 1 to 6 represent different combination cases of refractive indexes of the first phase retardation layer, the second phase retardation layer, and the first adhesive member in the polarizing plate. The first adhesive member used in the embodiments 1 to 6 and comparative example corresponds to an adhesive layer having a glass transition temperature in a range from about 40°C to about 150°C.

The evaluation results disclosed in table 1 represent whether a mura phenomenon is observed in the display device in which the polarizing plate is disposed on the display panel. In Table 1, the term of "Not seen" represents a case when mura caused by an interference phenomenon is not observed by naked eyes, and the term of "Seen" represents a case when mura phenomenon caused by an interference phenomenon is observed.

**[Table 1]**

| Classification | Constitution of polarizing plate | | | Whether mura is seen |
|---|---|---|---|---|
| | First phase retardation layer | First adhesive member | Second phase retardation layer | |
| Embodiment 1 | 1.8 | 1.6 | 1.8 | Not seen |
| Embodiment 2 | 1.8 | 1.7 | 1.8 | Not seen |
| Embodiment 3 | 1.7 | 1.5 | 1.7 | Not seen |
| Embodiment 4 | 1.7 | 1.6 | 1.7 | Not seen |
| Embodiment 5 | 1.6 | 1.7 | 1.8 | Not seen |
| Embodiment 6 | 1.6 | 1.75 | 1.6 | Not seen |
| Comparative example | 1.8 | 1.5 | 1.8 | Seen |

Referring to the results of Table 1, in the embodiments 1 to 6, a refractive index difference between the first adhesive member and each of the first and second phase retardation layers disposed adjacent thereto is about 0.25 or less. In the comparative example, a refractive index difference between the first adhesive member and each of the first and second phase retardation layers disposed adjacent thereto is about 0.3, which is greater than that of each of the embodiments 1 to 6.

As shown in Table 1 above, the display device according to the embodiments 1 to 6, which includes the polarizing plate in which the refractive index difference between the first adhesive member and each of the first and second phase retardation layers is adjusted to about 0.25 or less, is better in display quality than the display device according to the comparative example, in which the refractive index difference between the first adhesive member and each of the first and second phase retardation layers is greater than about 0.25 .

An embodiment of the polarizing plate includes, as the adhesive member, the pressure sensitive adhesive layer having a thickness in a range from about 2 $\mu$m to about 10 $\mu$m, to minimize the reflected light interference phenomenon generated between the optical layers and the adhesive member, thereby exhibiting improved optical characteristics.

An embodiment of the display device includes the polarizing plate including, as the adhesive member, the pressure sensitive adhesive layer having a thickness in a range from about 2 $\mu$m to about 10 $\mu$m, to minimize the mura phenomenon, in which mura is seen during usage of the display device, thereby exhibiting improved display quality.

An embodiment of the polarizing plate may improve the interference phenomenon of reflected light to exhibit improved optical characteristics by including the adhesive layer having a reduced refractive index difference from the optical layer or the pressure sensitive adhesive layer having an increased thickness.

An embodiment of the display device may exhibit the improved display quality by including the polarizing plate including the pressure sensitive adhesive layer having an increased thickness.

**Claims**

1. A polarizing plate (PP) comprising:

   a first phase retardation layer (RC1);
   a second phase retardation layer (RC2) disposed on the first phase retardation layer (RC1);
   a polarizer layer (POL) disposed on the second phase retardation layer (RC2); and
   a first adhesive member (AD1-a) disposed between the first phase retardation layer (RC1) and the second phase retardation layer (RC2)
   **characterized in that**
   the first adhesive member (AD1-a) is a pressure sensitive adhesive layer having a thickness in a range from about 2 micrometers to about 10 micrometers, wherein the pressure sensitive adhesive layer has a glass transition temperature in a range from about -45°C to about 0°C,
   the thickness of the pressure sensitive adhesive layer is larger than the thickness of each of the first and the second phase retardation layers (RC1, RC2), and
   each of the first and the second phase retardation layers (RC1, RC2) has a thickness in a range from about 0.5 micrometers to about 2 micrometers.

2. The polarizing plate (PP) of claim 1, wherein a refractive index difference between the pressure sensitive adhesive layer and the second phase retardation layer (RC2) is about 0.25 or less.

3. The polarizing plate (PP) of claim 1, wherein the first adhesive member (AD1-a) has a refractive index in a range from about 1.5 to about 1.8.

4. The polarizing plate (PP) of claim 1, wherein

   the first phase retardation layer (RC1) is a λ/4 phase retarder,
   the second phase retardation layer (RC2) is a λ/2 phase retarder, and
   the polarizer layer (POL) is a linear polarizer.

5. The polarizing plate (PP) of claim 1, wherein each of the first phase retardation layer (RC1) and the second phase retardation layer (RC2) is a liquid crystal coating layer.

6. The polarizing plate (PP) of claim 1, wherein

   the first phase retardation layer (RC1) is a nematic liquid crystal coating layer, and
   the second phase retardation layer (RC2) is a discotic liquid crystal coating layer.

7. The polarizing plate (PP) of claim 1, further comprising:
   a second adhesive member (AD2) disposed between the second phase retardation layer (RC2) and the polarizer layer (POL), and
   the second adhesive member (AD2) is a pressure sensitive adhesive layer having a glass transition temperature in a range from about -45°C to about 0°C or an adhesive layer having a glass transition temperature in a range from about 40°C to about 150°C.

8. The polarizing plate (PP) of claim 1, further comprising:

   a light compensation layer disposed below the first phase retardation layer (RC1), and
   the light compensation layer is a positive C-plate or a negative C-plate.

9. A display device (DD) comprising:

   a display panel (DP) comprising a light emitting element on the display panel (DP);
   a polarizing plate (PP) of at least one of claims 1 to 8.

**Patentansprüche**

1. Polarisationsplatte (PP), umfassend:

   eine erste Phasenverzögerungsschicht (RC1);
   eine zweite Phasenverzögerungsschicht (RC2), die auf der ersten Phasenverzögerungsschicht (RC1) angeordnet ist;
   eine Polarisatorschicht (POL), die auf der zweiten Phasenverzögerungsschicht (RC2) angeordnet ist; und
   ein erstes Klebeelement (AD1-a), das zwischen der ersten Phasenverzögerungsschicht (RC1) und der zweiten Phasenverzögerungsschicht (RC2) angeordnet ist,
   **dadurch gekennzeichnet, dass**
   das erste Klebeelement (AD1-a) eine druckempfindliche Klebeschicht mit einer Dicke in einem Bereich von etwa 2 Mikrometern bis etwa 10 Mikrometern ist, wobei die druckempfindliche Klebeschicht eine Glasübergangstemperatur in einem Bereich von etwa -45 °C bis etwa 0 °C aufweist,
   die Dicke der druckempfindlichen Klebeschicht größer ist als die Dicke jeder aus der ersten und der zweiten Phasenverzögerungsschicht (RC1, RC2), und
   jede aus der ersten und der zweiten Phasenverzögerungsschicht (RC1, RC2) eine Dicke in einem Bereich von etwa 0,5 Mikrometern bis etwa 2 Mikrometern aufweist.

2. Polarisationsplatte (PP) nach Anspruch 1, wobei ein Brechungsindexunterschied zwischen der druckempfindlichen Klebeschicht und der zweiten Phasenverzögerungsschicht (RC2) etwa 0,25 oder weniger beträgt.

3. Polarisationsplatte (PP) nach Anspruch 1, wobei das erste Klebeelement (AD1-a) einen Brechungsindex in einem Bereich von etwa 1,5 bis etwa 1,8 aufweist.

4. Polarisationsplatte (PP) nach Anspruch 1, wobei

   die erste Phasenverzögerungsschicht (RC1) ein $\lambda/4$-Phasenverzögerer ist, die zweite Phasenverzögerungsschicht (RC2) ein $\lambda/2$-Phasenverzögerer ist und
   die Polarisatorschicht (POL) ein linearer Polarisator ist.

5. Polarisationsplatte (PP) nach Anspruch 1, wobei jede aus der ersten Phasenverzögerungsschicht (RC1) und der zweiten Phasenverzögerungsschicht (RC2) eine Flüssigkristallüberzugsschicht ist.

6. Polarisationsplatte (PP) nach Anspruch 1, wobei

   die erste Phasenverzögerungsschicht (RC1) eine nematische Flüssigkristallüberzugsschicht ist und
   die zweite Phasenverzögerungsschicht (RC2) eine diskotische Flüssigkristallüberzugsschicht ist.

7. Polarisationsplatte (PP) nach Anspruch 1, ferner umfassend:

   ein zweites Klebeelement (AD2), das zwischen der zweiten Phasenverzögerungsschicht (RC2) und der Polarisatorschicht (POL) angeordnet ist, wobei
   das zweite Klebeelement (AD2) eine druckempfindliche Klebeschicht mit einer Glasübergangstemperatur in einem Bereich von etwa -45 °C bis etwa 0 °C oder eine Klebeschicht mit einer Glasübergangstemperatur in einem Bereich von etwa 40 °C bis etwa 150 °C ist.

8. Polarisationsplatte (PP) nach Anspruch 1, ferner umfassend:

   eine Lichtkompensationsschicht, die unter der ersten Phasenverzögerungsschicht (RC1) angeordnet ist, wobei die Lichtkompensationsschicht eine positive C-Platte oder eine negative C-Platte ist.

9. Anzeigevorrichtung (DD), umfassend:

   eine Anzeigetafel (DP), umfassend ein lichtemittierendes Element auf der Anzeigetafel (DP);
   eine Polarisationsplatte (PP) nach wenigstens einem der Ansprüche 1 bis 8.

**Revendications**

1. Plaque de polarisation (PP) comprenant :

   une première couche de retardement de phase (RC1) ;
   une seconde couche de retardement de phase (RC2) disposée sur la première couche de retardement de phase (RC1) ;
   une couche de polarisateur (POL) disposée sur la seconde couche de retardement de phase (RC2) ; et
   un premier organe adhésif (AD1-a) disposé entre la première couche de retardement de phase (RC1) et la seconde couche de retardement de phase (RC2)
   **caractérisée en ce que**
   le premier organe adhésif (AD1-a) est une couche adhésive sensible à la pression ayant une épaisseur dans une plage d'environ 2 micromètres à environ 10 micromètres, dans laquelle la couche adhésive sensible à la pression a une température de transition vitreuse dans une plage d'environ -45 °C à environ 0 °C,
   l'épaisseur de la couche adhésive sensible à la pression est supérieure à l'épaisseur de chacune des première et seconde couches de retardement de phase (RC1, RC2), et
   chacune des première et seconde couches de retardement de phase (RC1, RC2) a une épaisseur dans une plage d'environ 0,5 micromètre à environ 2 micromètres.

2. Plaque de polarisation (PP) selon la revendication 1, dans laquelle une différence d'indice de réfraction entre la couche adhésive sensible à la pression et la seconde couche de retardement de phase (RC2) est d'environ 0,25 ou moins.

3. Plaque de polarisation (PP) selon la revendication 1, dans laquelle le premier organe adhésif (AD1-a) a un indice de réfraction dans une plage d'environ 1,5 à environ 1,8.

4. Plaque de polarisation (PP) selon la revendication 1, dans laquelle

   la première couche de retardement de phase (RC1) est un retardateur de phase $\lambda/4$,
   la seconde couche de retardement de phase (RC2) est un retardateur de phase $\lambda/2$, et
   la couche de polarisateur (POL) est un polariseur linéaire.

5. Plaque de polarisation (PP) selon la revendication 1, dans laquelle chacune de la première couche de retardement de phase (RC1) et de la seconde couche de retardement de phase (RC2) est une couche de revêtement de cristaux liquides.

6. Plaque de polarisation (PP) selon la revendication 1, dans laquelle

   la première couche de retardement de phase (RC1) est une couche de revêtement de cristaux liquides nématiques, et
   la seconde couche de retardement de phase (RC2) est une couche de revêtement de cristaux liquides discotiques.

7. Plaque de polarisation (PP) selon la revendication 1, comprenant en outre :

   un second organe adhésif (AD2) disposé entre la seconde couche de retardement de phase (RC2) et la couche de polarisateur (POL), et
   le second organe adhésif (AD2) est une couche adhésive sensible à la pression ayant une température de transition vitreuse dans une plage d'environ -45 °C à environ 0 °C ou une couche adhésive ayant une température de transition vitreuse dans une plage d'environ 40 °C à environ 150 °C.

8. Plaque de polarisation (PP) selon la revendication 1, comprenant en outre :

   une couche de compensation de lumière disposée sous la première couche de retardement de phase (RC1), et
   la couche de compensation de lumière est une plaque C positive ou une plaque C négative.

9. Dispositif d'affichage (DD) comprenant :

un panneau d'affichage (DP) comprenant un élément émetteur de lumière sur le panneau d'affichage (DP) ;
une plaque de polarisation (PP) d'au moins l'une des revendications 1 à 8.

# FIG. 1

# FIG. 2

DD

RD

FA

FX

NFA

DR3

DR2

DR1

# FIG. 3

# FIG. 4

DD-a

FA-a

FX-a

NFA-a

DR3

DR2

DR1

# FIG. 5



# FIG. 6

# FIG. 7

# FIG. 8

# FIG. 9

PP-2

BF
POL
AD2
RC2
AD1
RC1
AD3
CP

DR3
DR1

# FIG. 10

DP

| NPXA | PXA-B | NPXA | PXA-G | NPXA | PXA-R | NPXA |

TFE

OH

PDL

DP-EL

DP-CL

BS

EL1  HTR  EML  ETR  EL2

OEL

EP 3 699 673 B1

**REFERENCES CITED IN THE DESCRIPTION**

**Patent documents cited in the description**

- US 2018149785 A1